# EUROPÄISCHE PATENTSCHRIFT

(11) **EP 4 297 111 B1**
(45) Veröffentlichungstag und Bekanntmachung des Hinweises auf die Patenterteilung: **26.02.2025**
(21) Anmeldenummer: 22180392.7
(22) Anmeldetag: 22.06.2022
(51) Int. Cl.: B29C 70/32, B29C 53/60, B29C 70/88, B29C 63/42

(54) **VERSTÄRKUNGSELEMENT FÜR EIN STRUKTURPROFIL, STRUKTURANORDNUNG, LUFT- ODER RAUMFAHRZEUG UND VERFAHREN ZUR HERSTELLUNG EINER STRUKTURANORDNUNG**
REINFORCING ELEMENT FOR A STRUCTURAL PROFILE, STRUCTURAL ARRANGEMENT, AIR OR SPACE VEHICLE AND METHOD FOR MANUFACTURING A STRUCTURAL ASSEMBLY
ÉLÉMENT DE RENFORT POUR UN PROFIL STRUCTURAL, AGENCEMENT STRUCTURAL, AÉRONEF OU VAISSEAU SPATIAL ET PROCÉDÉ DE FABRICATION D'UN AGENCEMENT STRUCTURAL

(43) Veröffentlichungstag der Anmeldung: 27.12.2023
(73) Patentinhaber: Airbus Operations GmbH, 21129 Hamburg (DE)
(72) Erfinder: Benthien, Hermann, 21129 Hamburg (DE); Hegenbart, Matthias, 21129 Hamburg (DE)

(56) Entgegenhaltungen:
- EP-A1- 2 539 475
- WO-A2-2006/121818
- DE-A1- 102018 212 442
- US-A1- 2015 280 102
- US-A1- 2020 122 815
- US-B1- 7 193 350

## Beschreibung

Die vorliegende Erfindung betrifft ein Verstärkungselement für ein Strukturprofil, eine Strukturanordnung, insbesondere für ein Luft- oder Raumfahrzeug, mit einem solchen Verstärkungselement, ein Luft- oder Raumfahrzeug mit einer solchen Strukturanordnung sowie ein Verfahren zur Herstellung einer solchen Strukturanordnung.

In der Luftfahrt werden Rohre aufgrund ihrer hohen Knicksteifigkeit als Strukturprofile zur lokalen Aufnahme axialer Lasten eingesetzt. Die DE 10 2008 041 230 A1 beschreibt die Anbringung einer Leitung an einer Traverse, die mit einem Rohr gebildet ist, mittels Haltern. Ferner ist die Anbringung des Rohrs an einer Rumpfzellenstruktur mittels Haltern beschrieben. Das Rohr weist dazu eine Vielzahl von Querbohrungen auf, die in einem Bohrungsraster eingebracht und zur formschlüssigen axialen Sicherung der Halter vorgesehen sind. Die Halter weisen Querstege mit zu den Bohrungen korrespondierenden Zapfen auf, die formschlüssig in die Bohrungen eingebracht sind.

Die Druckschrift DE 10 2018 218 039 A1 beschreibt ein Verstärkungselement mit einem hohlzylindrischen schraubenförmig gewickelten Geflecht von Fasersträngen, welche jeweils in ein thermoplastisches Matrixmaterial eingebettet sind, das durch Erhitzen schrumpfbar ist, um das Verstärkungselement über eine innere Mantelfläche an einem Strukturprofil zu befestigen. Die DE102018212442 A1 offenbart ein Verstärkungselement für ein Strukturprofil.

Vor diesem Hintergrund liegt der vorliegenden Erfindung die Aufgabe zugrunde, ein Verstärkungselement zu schaffen, welches eine vereinfachte Anbindung an ein Strukturprofil, insbesondere an ein Rohr, erlaubt.

Erfindungsgemäß wird diese Aufgabe gelöst durch ein Verstärkungselement für ein Strukturprofil mit den Merkmalen des Patentanspruchs 1, durch eine Strukturanordnung mit den Merkmalen des Patentanspruchs 3, durch ein Luft- oder Raumfahrzeug mit den Merkmalen des Patentanspruchs 8 und durch ein Verfahren mit den Merkmalen des Patentanspruchs 14.

Demgemäß ist ein Verstärkungselement für ein Strukturprofil, insbesondere für ein rundes, ovales oder elliptisches Strukturrohr, vorgesehen. Das Verstärkungselement umfasst eine Verbundstruktur, welche ein hohlzylindrisches schraubenförmig gewickeltes Geflecht von Fasersträngen aufweist, die eine zur Aufnahme des Strukturprofils ausgebildete innere Mantelfläche bilden, wobei die Faserstränge jeweils in ein Matrixmaterial eingebettet sind, welches ein elektroaktives Polymer aufweist, das durch Anlegen einer elektrischen Spannung entlang einer Längserstreckung der Faserstränge dehnbar ist, sodass die Verbundstruktur durch Anlegen der elektrischen Spannung ausdehnbar ist, um das Strukturprofil in die Verbundstruktur einzubringen, und durch Ausschalten der elektrischen Spannung schrumpfbar ist, um das Strukturprofil in der Verbundstruktur an der Mantelfläche zu fixieren.

Darüber hinaus ist eine Strukturanordnung, insbesondere für ein Luft- oder Raumfahrzeug, vorgesehen. Die Strukturanordnung umfasst ein Strukturprofil, insbesondere ein rundes, ovales oder elliptisches Strukturrohr, und ein das Strukturprofil lokal umgebendes erfindungsgemäßes Verstärkungselement, wobei die Verbundstruktur zur Aufbringung einer Zugsspannung geschrumpft und auf diese Weise kraftschlüssig mit dem Strukturprofil verbunden ist.

Ferner ist ein Luft- oder Raumfahrzeug mit einer erfindungsgemäßen Strukturanordnung vorgesehen.

Zudem ist ein Verfahren zur Herstellung einer Strukturanordnung, insbesondere einer erfindungsgemäßen Strukturanordnung, vorgesehen. Das Verfahren umfasst Anordnen eines ungeschrumpften erfindungsgemäßen Verstärkungselements auf einem Strukturprofil unter Anlegen einer elektrischen Spannung derart, dass die innere Mantelfläche das Strukturprofil lokal umgibt; Vornehmen eines Toleranzausgleichs durch Verschieben des Verstärkungselements entlang des Strukturprofils in eine finale Position; und Abschalten der elektrischen Spannung zum Befestigen der inneren Mantelfläche an dem Strukturprofil durch Schrumpfen der Verbundstruktur.

Eine der vorliegenden Erfindung zugrundeliegende Idee besteht darin, die Funktionsprinzipien von sogenannten Extensionshülsen, auch Fingerfallen genannt, die sich bei Zugbelastung verjüngen, zur Verstärkung bzw. crashsicheren Lasteinleitung für Strukturprofile, insbesondere Strukturrohre, im Luft- und Raumfahrtbereich einzusetzen. Dem liegt unter anderem die Erkenntnis zugrunde, dass die Knicksteifigkeit eines Profils, insbesondere eines Rohrs, durch eine äußere Drucckraft erhöht wird. Ferner können basierend auf diesen Wirkprinzipien Abschnitte von Strukturprofilen bzw. Teilkomponenten kraftschlüssig miteinander verbunden werden, beispielsweise Längsabschnitte von Strukturrohren (Rohrverbindungen).

Da der Innendruck bei einer Extensionshülse mit steigender Belastung konstruktionsbedingt weiter ansteigt, liegt somit eine selbstverstärkende Verbindung bzw. Verstärkung vor.

Erfindungsgemäß wird dazu ein schraubenförmig gewickelten Geflecht aus Fasersträngen als Verstärkungs- und/oder Verbindungselement eingesetzt, wobei die Faserstränge jeweils in ein elektroaktives Polymer als Matrixmaterial eingebettet sind, welches sich unter Anlegung einer elektrischen Spannung entlang einer Faserlängserstreckung ausdehnt. In der Mitte ist das Verstärkungselement hohl, sodass eine zum Aufschieben oder Auffädeln auf ein Strukturprofil vorgesehene Hülse geschaffen ist, welche sich bei Zugbelastung radial zuzieht. Das Verstärkungselement kann dabei kraftschlüssig an einem Strukturprofil befestigt werden, bzw. zur kraftschlüssigen Verbindung zweier Elemente eingesetzt werden, indem zunächst eine elektrische Spannung angelegt wird, welche die Verbundstruktur ausdehnt und diese derart positionierbar macht. Sobald die Verbundstruktur in der finalen Montageposition angekommen ist, in welcher sie das Strukturprofil bzw. die zu verbindenden Teilkomponenten zumindest lokal umgibt, wird die Spannung wieder abgeschaltet. Durch den Wegfall der elektrischen Spannung schrumpft die Verbundstruktur zurück auf ihre ursprüngliche Ausdehnung. Bei entsprechender Einstellung der geometrischen Gegebenheiten kann somit ein Strukturprofil aufgrund des derart aufgebrachten Drucks verstärkt werden bzw. es können Profilkomponenten eines Strukturprofils aneinander befestigt werden.

Bei einer Ausführungsform kann das Strukturprofil auch eine Ausbildung aufweisen, die eine gewisse formschlüssige Befestigung des geschrumpften Verstärkungselements bewirkt. Beispielsweise können regelmäßig oder unregelmäßig bzw. lokal Erhebungen an der äußeren Oberfläche des Strukturprofils vorgesehen sein, um welche sich das Verstärkungselement beim Schrumpfen legt und diese somit in axialer Richtung hintergreift.

Erfindungsgemäß kann eine zweistufige kraftschlüssige Befestigung erreicht werden. Zum einen kann die Verbundstruktur entsprechend ausgelegt sein, dass durch Schrumpfung ein umlaufender Druck auf das Strukturprofil und somit ein Kraftschluss zwischen der inneren Mantelfläche und der äußeren Oberfläche des Strukturprofils hergestellt wird. Bei zunehmender Zugbeanspruchung wird der Druck und damit der Kraftschluss zusätzlich durch das radiale Zuziehen des Geflechts verstärkt. Auf diese Weise lassen sich die Eigenschaften des erfindungsgemäßen Verstärkungselements derart einstellen, dass eine zur Anbindung axialer Lasten in mehrfacher Hinsicht vorteilhafte Wirkung erzielt wird.

Dabei kann das Strukturprofil bereits mit dem durch die Schrumpfung aufgebrachten Druck lokal hinsichtlich seiner Knicksteifigkeit verstärkt werden. Es kann zudem ein für eine Befestigung eines für Axiallasten vorgesehenen Krafteinleitungselements unter normalen Lasten, insbesondere Fluglasten, ausreichender Kraftschluss geschaffen werden. Zusätzlich kann die Verbundstruktur mit ihrem Geflecht bei Auftreten einer über das normale Maß hinausgehenden Zugkraft, insbesondere im Crashfall auftretenden Überlasten, einen zusätzlichen sehr starken Druck durch das Zusammenziehen des Gewebes aufbringen, welcher selbsthelfend einerseits die Knicksteifigkeit des Strukturprofils temporär stark erhöht und zudem den Kraftschluss temporär massiv verstärkt. Dies erlaubt eine völlig neue Auslegung bei der Anbindung zur Aufnahme von axialen Lasten an Strukturprofilen.

Im Ergebnis können Strukturprofile, insbesondere Strukturrohre, durch die lokal einstellbare zusätzliche Aussteifung kleiner bzw. dünner dimensioniert werden. Ferner werden Ausnehmungen, wie Bohrungen oder dergleichen, in den Rohren erfindungsgemäß vermieden, sodass nicht nur die Steifigkeit sondern auch die Festigkeit der Struktur verbessert wird. Insgesamt ist also eine deutliche Gewichtsreduktion erzielbar. Anders als im Stand der Technik ist keine Temperaturbeaufschlagung notwendig, da kein thermoplastisches Matrixmaterial geschrumpft werden muss. Vielmehr kann eine geeignete Schrumpfung bzw. Ausdehnung durch An- und Abschalten einer elektrischen Spannung wiederholt umgesetzt werden. Der vorliegenden Verbindungsschluss ist somit wiederholt lösbar. Dies macht die Montage noch einmal einfacher, kostengünstiger und schneller gegenüber bekannten Lösungen.

Zudem besteht erfindungsgemäß vorteilhaft völlige Freiheit bei der Positionierung, ohne dass dazu eine Vorbereitung des Strukturprofils nötig ist. Insbesondere kann der ungeschrumpfte Zustand des Verstärkungselements zur einfachen toleranzausgleichenden Montage und freien axialen Positionierung des Verstärkungselements ausgenutzt werden. Somit werden bei der Montage Maßnahmen zum Toleranzausgleich, wie Gewindehülsen oder dergleichen, überflüssig. Durch geschickte Wahl der Montagereihenfolge und Abschalten der elektrischen Spannung erst am Ende der Montage, wenn eine finale Positionierung der anzubindenden Komponenten hergestellt ist, lässt sich die Befestigung ggfs. sogar bei schlechter Zugänglichkeit der Anbindungsstellen im montierten Zustand herstellen.

Weiterhin können unterschiedliche Materialien in der Verbundstruktur für unterschiedliche Anwendungen miteinander kombiniert werden. So kann beispielsweise durch Ergänzung des elektroaktiven Polymers um ein Elastomer (z.B. Gummi) eine Dichtungsfunktion umgesetzt werden: Lücken innerhalb des Geflechts, welche in einem ausgedehnten Zustand vorhanden sein mögen, können bei geeigneter Schrumpfung aufgrund des Schrumpfungseffekts vollständig fluiddicht geschlossen werden. Derart können beispielsweise Rohrabschnitte fluiddicht miteinander gekoppelt werden. Es versteht sich dabei, dass das Matrixmaterial weitere Komponenten aufweisen kann und zudem unterschiedliche Fasermaterialien zum Einsatz kommen können, z.B. Kohlenstofffasern, Glasfasern, Aramidfasern, Dyneemafasern etc.

Auch wenn die Erfindung besondere Vorteile für runde, ovale oder elliptische Strukturrohre bietet, ist ihre Anwendung hierauf nicht beschränkt. Vielmehr lassen sich grundsätzlich auch anderweitig geformte Profile miteinander verbinden bzw. verstärken. Aufgrund des verwendeten Fasermaterials kann es dabei allerdings vorteilhaft sein, wenn die Auflagefläche für das Fasermaterial eine mehr oder weniger abgerundete Oberfläche aufweist, bzw. sich zumindest keine spitzen Kanten unter dem Fasermaterial befinden.

Vorteilhafte Ausgestaltungen und Weiterbildungen ergeben sich aus den weiteren Unteransprüchen sowie aus der Beschreibung unter Bezugnahme auf die Figuren.

Gemäß einer Weiterbildung können die Faserstränge jeweils zusammen mit dem Matrixmaterial Materialstreifen bilden, die um die Mantelfläche schraubenförmig herum gewickelt sind. Die Verbundstruktur wird somit durch ein Geflecht von Bändern aus einer Materialkombination aus Fasern und elektroaktivem Polymer gebildet. In dieser Weiterbildung ist das Geflecht und damit die Verbundstruktur besonders einfach und kostengünstig in der Herstellung.

Gemäß einer Weiterbildung kann jeder Faserstrang einzeln in das Matrixmaterial eingebettet sein. Auf diese Weise ist mit jedem Faserstrang ein Verbundfaden gebildet. Ein Faserstrang kann dabei eine Vielzahl von parallelen Fasern und/oder eine Vielzahl von parallelen Faserbündeln aufweisen. Das Geflecht ist entsprechend als Geflecht von derartigen Verbundfäden ausgebildet. Dementsprechend bilden die Verbundfäden das hohlzylindrische schraubenförmig gewickelte Geflecht. Auf diese Weise wird vorteilhaft ein einfaches Abgleiten der Verbundfäden aneinander ermöglicht, sodass sich das Geflecht mit weniger Widerstand bzw. leichter zuziehen kann. Die Gleiteigenschaften können ferner, beispielsweise durch unterschiedlich intensive nachgelagerte Konsolidierungsschritte, eingestellt werden, sodass eine Eingriffsschwelle für die zuziehende Wirkung des Gewebes vorbestimmbar ist.

Gemäß einer Weiterbildung kann das Strukturprofil zwei Längsabschnitte aufweisen. Das Verstärkungselement kann zwei einander gegenüberliegende Enden der jeweiligen Längsabschnitte umgeben und die beiden Längsabschnitte derart miteinander verbinden. Somit kann das Verstärkungselement auch zur Verbindung von Strukturprofilteilkomponenten verwendet werden, z.B. für Rohrverbindungen eines Strukturrohrs.

Gemäß einer Weiterbildung kann das Verstärkungselement zur Versteifung des Strukturprofils ausgebildet und angeordnet ein. Insbesondere kann das Verstärkungselement zur lokalen Knickversteifung vorgesehen sein. Entsprechend wird es in denjenigen Bereichen angebracht, an welchen, insbesondere abhängig von dem vorherrschenden Eulerschen Fall der Lagerung des Strukturprofils, ein Ausknicken des Strukturprofils zu erwarten ist. Denkbar wäre auch, das Verstärkungselement zwischen den Lagerstellen des Strukturprofils durchgängig vorzusehen und die Knicksteifigkeit somit durchgehend zu erhöhen.

Gemäß einer Weiterbildung kann das Verstärkungselement zur Einleitung von axialen Lasten in das Strukturprofil ausgebildet und angeordnet sein. Auf diese Weise lässt sich der für den Kraftschluss aufgebrachte Druck zur Abstützung von Lasten nutzen. Ferner lassen sich die axialen Lasten als Zuglast auf das Verstärkungselement aufbringen, sodass sich das Geflecht ab einer vorbestimmten Zugbeanspruchung zuzieht. Bei einer das Verstärkungselement längenden Zugbelastung lasst sich das Geflecht somit synergetisch zur zusätzlichen temporären Aussteifung des Strukturprofils und zur zusätzlichen temporären Verstärkung des Kraftschlusses nutzen.

Gemäß einer Weiterbildung kann das Verstärkungselement eine mit der Verbundstruktur gekoppelte Aufnahme aufweisen, die zur Übertragung von axialen Lasten auf die Verbundstruktur ausgebildet ist. Die Aufnahme, oder zumindest Teile der Aufnahme, können dabei einteilig mit dem Verstärkungselement ausgebildet sein. Es kann sich jedoch auch um eine nachträglich an das Verstärkungselement anbringbare Aufnahme handeln. Die Aufnahme kann mehrteilig ausgebildet sein.

Gemäß einer Weiterbildung kann die Verbundstruktur derart ausgelegt sein, dass sich das Geflecht von Fasersträngen bei axialer Zugbelastung axial längt und radial zusammenzieht, sodass sich der Kraftschluss mit dem Strukturprofil selbsttätig verstärkt. Dies wird insbesondere durch die hohlzylindrische schraubenförmig gewickelte Struktur des Geflechts erreicht. Insbesondere handelt es sich dabei um ein biaxiales Geflecht. Ein solches schraubenförmiges biaxiales Geflecht weist keinerlei axiale Faserstränge auf, sodass die komplette Zugkraft in eine axiale Längung und ein radiales Zusammenziehen des Geflechts umgesetzt wird.

Gemäß einer Weiterbildung des Luft- oder Raumfahrzeugs kann das Strukturprofil als an eine Primärstruktur des Luft- oder Raumfahrzeugs angebundenes Strukturrohr zur Anbindung von zumindest einer Komponente an die Primärstruktur ausgebildet sein.

Gemäß einer Weiterbildung des Luft- oder Raumfahrzeugs kann das Strukturprofil, insbesondere ein Strukturrohr, axial an einer Rumpfstruktur des Luft- oder Raumfahrzeugs angeordnet sein. Auf diese Weise können axiale Lasten von Komponenten, sowohl herkömmliche Fluglasten als auch Crashlasten, an dem Strukturprofil abgestützt werden. Beispielsweise kommen als derartige axial abstützbare Komponenten Bordküchen, Bordtoiletten oder andere Kabinenmonumente infrage. Vorteilhaft ist somit eine einerseits leicht montierbare toleranzausgleichende Abstützung geschaffen, die zudem eine einfache parallele Leitungsführung und eine hohe Crashsicherheit bietet.

Gemäß einer Weiterbildung kann die zumindest eine Komponente über das Verstärkungselement an das Strukturrohr angebunden sein. Alternativ oder zusätzlich kann auch das Strukturrohr über das Verstärkungselement an der Primärstruktur angebunden sein. Das Verstärkungselement ist somit sowohl zur Verbindung des Strukturrohrs mit einer anzubindenden Komponente bzw. Sekundärstruktur als auch zur Anbindung des Strukturrohrs an eine Primärstruktur, insbesondere eine Flugzeugrumpfstruktur, geeignet. Somit lässt sich die gesamte Montage vorteilhaft vereinfacht planen. Insbesondere sind sämtliche toleranzausgleichende Arbeitsschritte überflüssig.

Zur Anbindung der Komponente über das Verstärkungselement an das Strukturrohr wird die Komponente in ihrer Einbausituation an das Verstärkungselement angelenkt und erst anschließend das die Komponente anbindende Verstärkungselement zur Befestigung geschrumpft (d.h. die anliegende elektrische Spannung wird abgeschaltet und die Verbundstruktur dadurch geschrumpft).

Zur Anbindung des Strukturrohrs über das Verstärkungselement an die Primärstruktur kann das Strukturrohr in einfacher Weise an sämtlichen Befestigungspunkten positioniert und anschließend die das Strukturrohr anbindenden Verstärkungselemente zur Befestigung geschrumpft werden. Selbstverständlich ist dies auch schrittweise, beispielsweise von Spant zu Spant eines Rumpfes, möglich.

Gemäß einer Weiterbildung kann die Verbundstruktur zur formstabilen Übertragung von herkömmlichen Fluglasten durch den mit der Schrumpfung der Verbundstruktur aufgebrachten Kraftschluss auf das Strukturrohr ausgelegt sein. Entsprechend tritt ohne außergewöhnliche Belastungen auch keine Verformung auf, sodass sich das Gewebe bei herkömmlichen Lasten noch nicht oder lediglich reversibel zuzieht und sich das Material nicht oder lediglich reversibel bzw. elastisch verformt. Vorteilhaft sind somit Materialien, die eine hohe Festigkeit gewährleisten.

Gemäß einer Weiterbildung kann die Verbundstruktur zur formverändernden Übertragung von axialen Überlasten auf das Strukturprofil durch axiales Längen und radiales Zusammenziehen ausgelegt sein. Bei derartigen Überlasten kann es sich insbesondere um Crashlasten handeln. Auf diese Weise trägt das Verstärkungselement zu einer über die originär durch das Schrumpfen erreichte Knicksteifigkeit nochmals temporär deutlich hinausgehende Knicksteifigkeit der Verbindungsanordnung im Überlastfall, insbesondere im Crashfall, bei und sorgt zudem für eine in diesem Überlastfall sichere Befestigung durch einen temporär verstärkten Kraftschluss.

Gemäß einer Weiterbildung des erfindungsgemäßen Verfahrens kann das Verstärkungselement zur Anbindung einer Komponente an das Strukturprofil ausgebildet sein, wobei das Vornehmen des Toleranzausgleichs das Koppeln der Komponente mit dem Verstärkungselement und ein finales Positionieren der Komponente in ihrer Einbauposition umfasst, sodass die Komponente durch das Schrumpfen der Verbundstruktur des Verstärkungselements in der Einbauposition an das Strukturprofil angebunden wird. Auf diese Weise ist zum Toleranzausgleich vorteilhaft keinerlei zusätzlicher Arbeitsschritt nötig. Vielmehr wird durch eine geschickte Veränderung der Reihenfolge üblicher Montageschritte, welche durch das dem erfindungsgemäße Verstärkungselement ermöglicht ist, der Toleranzausgleich automatisch erreicht.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

Die vorliegende Erfindung wird nachfolgend anhand der in den schematischen Figuren angegebenen Ausführungsbeispiele näher erläutert. Es zeigen dabei:
- Fig. 1: eine schematische Ansicht eines Verstärkungselements gemäß einer Ausführungsform der Erfindung mit und ohne angelegte elektrische Spannung;
- Fig. 2: eine Draufsicht auf das Verstärkungselement aus Fig. 1, welches auf ein Strukturprofil aufgebracht ist;
- Fig. 3-5: Längs- und Querschnittsansichten des Verstärkungselements und Strukturprofils gemäß Fig. 2 während unterschiedlicher Montageschritte;
- Fig. 6: eine Längsschnittansicht einer Strukturanordnung gemäß einer Ausführungsform der Erfindung;
- Fig. 7: eine Querschnittansicht der Strukturanordnung nach Fig. 6;
- Fig. 8: eine Draufsicht auf die Strukturanordnung nach Fig. 6 und 7;
- Fig. 9: eine Draufsicht auf eine Strukturanordnung gemäß einer weiteren Ausführungsform der Erfindung;
- Fig. 10: eine Draufsicht auf eine Strukturanordnung gemäß einer noch weiteren Ausführungsform der Erfindung;
- Fig. 11: eine Draufsicht auf ein Luft-oder Raumfahrzeug; und
- Fig. 12: ein schematisches Flussdiagramm für ein Verfahren zur Herstellung einer Strukturanordnung gemäß einer Ausführungsform der Erfindung.

Die beiliegenden Figuren sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

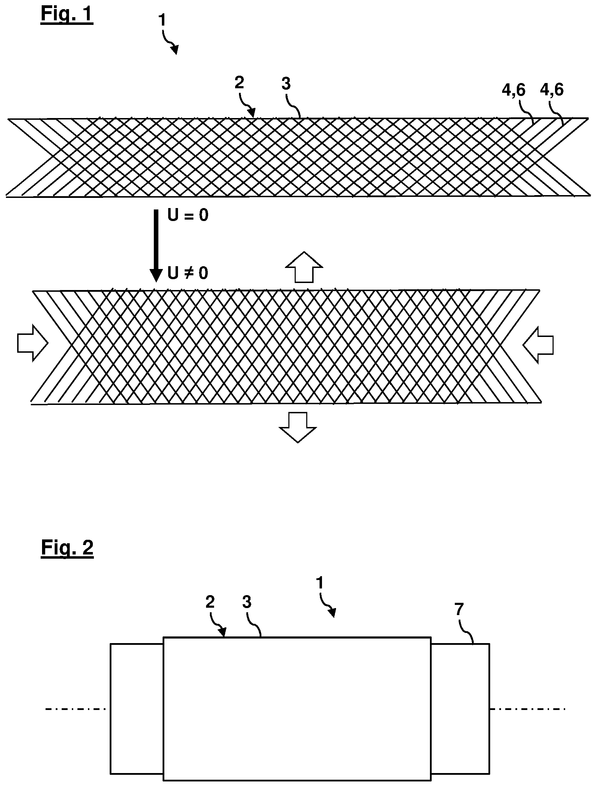

Figur 1 zeigt eine schematische Ansicht eines Verstärkungselements 1 gemäß einer Ausführungsform der Erfindung mit und ohne angelegte elektrische Spannung U.
Fig. 2 bis 5 zeigen die Montage des Verstärkungselements 1 auf einem Strukturprofil 7.

Das Verstärkungselement 1 ist hohlzylindrisch ausgebildet und für die Verstärkung des Strukturprofils 7 vorgesehen, wozu es darauf aufgeschoben ist. Das Verstärkungselement 1 ist mit einer Verbundstruktur 2 gebildet. Die Verbundstruktur 2 enthält ein hohlzylindrisches schraubenförmig gewickeltes Geflecht 3 von Fasersträngen 4, welche jeweils in ein Matrixmaterial 6 eingebettet sind. Die Verbundstruktur 2 bildet so eine zur Aufnahme des Strukturprofils 7 ausgebildete innere Mantelfläche 5.

Bei der dargestellten Ausführungsform sind die Faserstränge 4 jeweils zusammen mit dem Matrixmaterial 6 als Materialstreifen ausgebildet, welche um die Mantelfläche 5 schraubenförmig herum gewickelt sind. Dabei kann jeder Faserstrang 4 einzeln in das Matrixmaterial 6 eingebettet sein. Auf diese Weise ist eine Vielzahl von Verbundfäden vorgesehen, wobei das Geflecht als hier von außen erkennbares Geflecht von derartigen Verbundfäden ausgebildet ist. Alternativ können ebenso mehrere Faserstränge gemeinsam in jeweils einen Materialstreifen aus Matrixmaterial 6 eingebettet sein.

Das Matrixmaterial 6 umfasst hierbei ein elektroaktives Polymer, das durch Anlegen einer elektrischen Spannung U entlang einer Längserstreckung der Faserstränge 4, d.h. der Materialstreifen, dehnbar ist. Das Matrixmaterial 6 ist dabei derart ausgebildet, dass die Verbundstruktur 2 durch Anlegen der elektrischen Spannung U ausdehnbar ist, um das Strukturprofil 7 in die Verbundstruktur 2 einzubringen (unten in Fig. 1), und durch Ausschalten der elektrischen Spannung U schrumpfbar ist (oben in Fig. 1), um das Strukturprofil 7 in der Verbundstruktur 2 an der Mantelfläche 5 zu fixieren, indem es bei dem Schrumpfen eine umfängliche Zugkraft aufbringt.

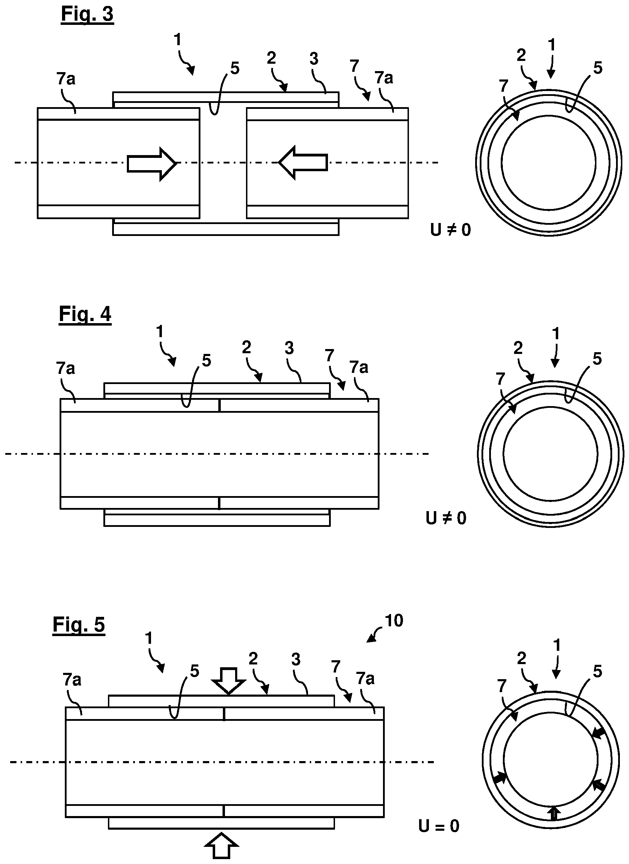

Fig. 3 bis 5 zeigen zur Illustration dieser Funktionsprinzipien eine beispielhafte Montagreihenfolge. Wie dabei Fig. 3 bis 5 entnommen werden kann, handelt es sich bei dem Strukturprofil 7 beispielsweise um ein rundes Rohr. Selbstverständlich sind bei weiteren Ausführungsformen andere Profilquerschnitte möglich. Ferner kann diesen Figuren entnommen werden, dass das Strukturprofil 7 beispielsweise zwei Längsabschnitte 7a aufweisen kann, die über das Verstärkungselement 1 miteinander verbunden werden. Es versteht sich jedoch, dass das Verstärkungselement 1 ebenso an einem einteiligen Strukturrohr anbringbar ist.

In Fig. 3 liegt eine Spannung an dem Matrixmaterial 6 an und die Verbundstruktur 2 befindet sich aufgrund dieser Aktuierung des elektroaktiven Polymers in dem ausgedehnten (aufgeweiteten) Zustand, in welchem das Strukturprofil 7 zwischen die Mantelfläche 5 einschiebbar ist. In diesem Fall werden hierzu beide Längsabschnitte 7a von jeweils einer Seite eingeschoben, sodass das Verstärkungselement 1 zwei gegenüberliegende Enden der jeweiligen Längsabschnitte 7a umgibt.

Das Verstärkungselement 1 ist in dem hier dargestellten ungeschrumpften Zustand mit einem vorbestimmten Spiel auf das Strukturprofil 7 aufgebracht, sodass es das Strukturprofil 7 umgibt und in der axialen Richtung verschiebbar ist. Entsprechend ist zumindest abschnittsweise ein Abstand bzw. ein Spielsitz zwischen der inneren Mantelfläche 5 der Verbundstruktur 2 und einer äußeren Oberfläche des Strukturprofils 7 vorgesehen, der eine einfache Verschiebbarkeit gewährleistet. Die hier dargestellte konzentrische Anordnung mit einem vergleichsweise großen Zwischenraum zwischen Strukturprofil 7 und Verstellungselement 1 ist rein illustrativ zu verstehen. Ein Spiel kann tatsächlich auch vergleichsweise klein vorgesehen sein. Insbesondere kann es sich um eine Spielpassung handeln, welche aber noch eine einfache Verschiebbarkeit des Verstärkungselements entlang des Strukturprofils 7 erlaubt.

In Fig. 4 ist dieser Vorgang abgeschlossen und die beiden Längsabschnitte 7a liegen aneinander innerhalb der Mantelfläche 5 an. In Fig. 5 wird nun die angelegte elektrische Spannung U abgeschaltet was zu einer Schrumpfung der Verbundstruktur 2 führt (vgl. Pfeile). Die Bauteile 1, 7 können dabei derart ausgelegt werden, dass hierdurch eine umlaufende Zugkraft und um das gesamte Strukturprofil 7 herum ein flächiger Druck generiert wird (wie mit den an der inneren Mantelfläche 5 eingezeichneten Pfeilen symbolisiert).

Der gleichmäßige Druck auf das Strukturprofil 7 führt einerseits zu einem Kraftschluss zwischen dem Verstärkungselement 1 und Strukturprofil 7, sodass das Verstärkungselement 1 durch das Schrumpfen an dem Strukturprofil 7 befestigt wird und mit diesem eine Strukturanordnung 10 bildet. Zusätzlich erhöht der umlaufend aufgebrachte Druck die Knicksteifigkeit des Strukturprofils 7. Gleichzeitig wird ein Verbindungsschluss zwischen den beiden Längsabschnitten 7a des Strukturprofils 7 geschaffen.

Eine derartige Strukturanordnung 10 ist beispielsweise für ein Luft- oder Raumfahrzeug zur Abstützung von X-Lasten, d. h. in Flugrichtung wirkenden Lasten, einsetzbar. Je nach Struktur eines derartigen Luft- oder Raumfahrzeugs kann ein Strukturprofil 7 in unterschiedlicher Weise ausgebildet sein. Selbstverständlich kann es sich um ein Metallprofil handeln, denkbar wäre aber auch ein Faserverbundprofil vorzusehen.

Bei der dargestellten Ausführungsform handelt es sich um einen Hohlprofilquerschnitt. Dementsprechend handelt es sich bei dem Strukturprofil um ein Rohr. Derartige Profilquerschnitte weisen vorteilhaft hohe Knicksteifigkeiten auf, welche insbesondere zur gerichteten Lastabstützung vorteilhaft sind. Bei weiteren Ausführungsformen wäre aber auch ein massives Strukturprofil 7 denkbar.

Das Strukturprofil 7 ist lokal von dem Verstärkungselement 1 umgeben, wie es in Bezug auf die Figuren beschrieben ist. Die Verbundstruktur 2 des Verstärkungselements 1 ist zur Aufbringung einer Zugsspannung geschrumpft. Auf diese Weise ist ein Kraftschluss zwischen dem Verstärkungselement 1 und dem Strukturprofil 7 hergestellt und ein lokaler umlaufender Druck auf das Strukturprofil 7 aufgebracht.

Bei der dargestellten Ausführungsform ist das Verstärkungselement 1 zur lokalen Knickversteifung des Strukturprofils 7 ausgebildet und angeordnet. Entsprechend weist die Strukturanordnung 10 im Bereich des Verstärkungselements 1 durch den aufgebrachten Druck eine erhöhte Knicksteifigkeit auf.

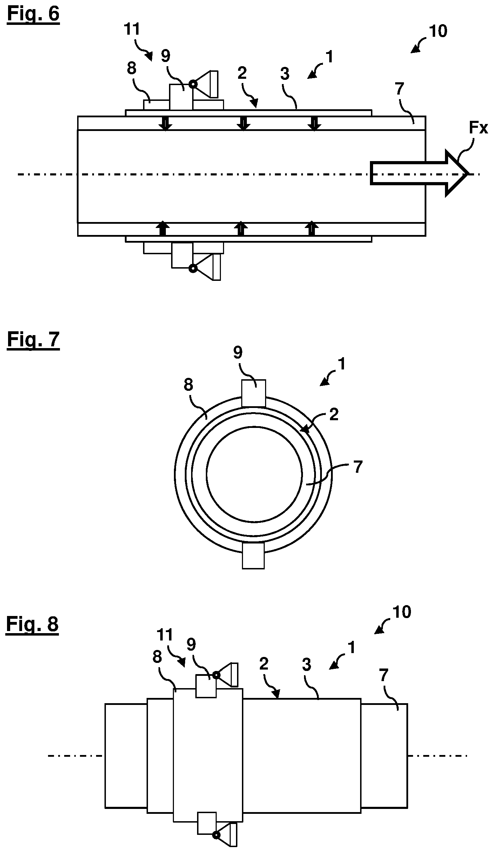

Fig. 6 zeigt eine Längsschnittansicht einer Strukturanordnung 10 gemäß einer weiteren Ausführungsform.

Zusätzlich zu der knickversteifenden Wirkung ist das Verstärkungselement 1 hier auch zur Einleitung von axialen Lasten in das Strukturprofil 7 ausgebildet. Dazu weist das Verstärkungselement 1 eine mit der Verbundstruktur 2 gekoppelte Aufnahme 11 auf, die zur Übertragung von axialen Lasten, die hier mit einem Pfeil Fx symbolisiert sind, auf die Verbundstruktur 2 ausgebildet ist.

Die Aufnahme 11 umfasst einerseits eine die Verbundstruktur 2 im Bereich eines längsseitigen Endes der Verbundstruktur 2 umgreifende Schelle 8. Bei der Schelle 8 handelt es sich vorzugsweise um eine ununterbrochene hülsenförmige Schelle 8. Denkbar wäre bei weiteren Ausführungsformen aber auch eine, insbesondere mit einer Vorspannung beaufschlagte, unterbrochene Schelle 8 vorzusehen.

Die Schelle 8 ist umlaufend mit der Verbundstruktur 2 verbunden. Dazu sind sowohl formschlüssige als auch stoffschlüssige Verbindungen denkbar.

Beispielsweise kann die Aufnahme 11 stoffschlüssig über das Matrixmaterial 6 mit der Verbundstruktur 2 koppelbar bzw. gekoppelt sein. Beispielsweise ist die Schelle 8 mit dem Verstärkungselement 1 integriert ausgebildet, wobei auch für die Schelle schrumpfbare bzw. ausdehnbare Materialien zur Anwendung kommen können. Dazu kann sie im Falle eines in das Matrixmaterial 6 gemeinsam eingebetteten Gewebes 3 bereits bei der Herstellung mit eingebettet werden. Andernfalls kann die Schelle 8 nachträglich mit dem Matrixmaterial verbunden werden.

Die Schelle 8 weist ein oder mehrere Krafteinleitungselemente 9 auf. In der dargestellten Ausführungsform handelt es sich dabei um zwei gegenüberliegend angeordnete Anlenkungspunkte, welche jeweils eine Lagerung mit zumindest einem rotatorische Freiheitsgrad zulassen. Es kann sich dabei insbesondere um eine Bolzenlagerung handeln. Denkbar sind jedoch auch zweiachsige Lagerungen oder Kugelgelenklager. Auf diese Weise wird die Übertragung von Momenten auf das Strukturprofil 7 vermieden und so die zielgerichtete Abstützung von hier mit einem Pfeil Fx symbolisierten axialen Lasten über die Krafteinleitungselemente 9 sichergestellt.

Wird über ein derartiges Krafteinleitungselement 9 eine Zugkraft Fx auf das Verbindungselement 1 aufgebracht, so wird diese zunächst über die geschrumpfte Verbundstruktur 2 auf das Strukturprofil 7 übertragen. Vorzugsweise ist das Verstärkungselement 1 derart ausgelegt, dass in dieser Weise die üblichen Betriebslasten übertragen werden können, insbesondere Fluglasten im Fall eines Luft- oder Raumfahrzeugs. Entsprechend ist die Verbundstruktur 2 zur formstabilen Übertragung von herkömmlichen Fluglasten durch den mit der Schrumpfung aufgebrachten Kraftschluss auf das Strukturrohr ausgelegt.

Treten jedoch überhöhte Lasten auf, beispielsweise im Crashfall, kommt die besondere Funktionalität des Geflechts 3 zum Tragen. Die Verbundstruktur 2 ist derart ausgelegt, dass sich das Geflecht 3 von Fasersträngen 4 bei überhöhter axialer Zugbelastung Fx axial längt und radial zusammenzieht, so dass ein zusätzlicher Druck auf das Strukturprofil aufgebracht wird und sich der Kraftschluss mit dem Strukturprofil 7 selbsttätig verstärkt. Entsprechend ist die Verbundstruktur 2 zur formverändernden Übertragung von axialen Überlasten Fx, insbesondere Crashlasten, auf das Strukturprofil durch axiales Längen und radiales Zusammenziehen ausgelegt.

Das Geflecht 3 ist dazu beispielsweise als biaxiales schraubenförmiges Geflecht aus Materialstreifen ausgebildet, wobei keine Fasern bzw. Streifen in X-Richtung, die insbesondere die Flugrichtung darstellt, vorhanden sein können. Ein solches Geflecht 3 ist in der Lage, sich bei einer Zugkraft zu Längen und gleichzeitig seinen Durchmesser zu verringern bzw. sich radial zuzuziehen. Dabei ist eine Auslegung möglich, welche diesen Mechanismus bei einer vorbestimmten Zugkraftschwelle, insbesondere lediglich bei überhöhter Last, zum Tragen kommen lässt.

Der bei Angreifen einer überhöhten Zugkraft Fx zusätzlich wirkende Druck auf das Strukturprofil 7 ist hier mit weiteren an der inneren Mantelfläche 5 angreifenden Pfeilen illustriert. Auf diese Weise wird einerseits die Befestigung durch Kraftschluss gestärkt und zudem die lokale Knicksteifigkeit des Strukturprofils 7 nochmals zusätzlich erhöht. Es handelt sich somit um eine selbsthelfende Ausbildung und Auslegung des Verstärkungselements, da dieses in der Lage ist, bei höherer Belastung die Haltekräfte und auch die Versteifungskräfte selbsttätig zu erhöhen.

Fig. 7 zeigt eine Querschnittansicht der Strukturanordnung 10 nach Fig. 6.

Erkennbar ist die Schelle 8 hier umlaufend ausgebildet. Die Krafteinleitungselemente 19 sind an zwei gegenüberliegenden Stellen in einer Ausnehmung der Schelle 8 aufgenommen, beispielsweise formschlüssig. Bei weiteren Ausführungsformen wäre auch eine integrale Ausbildung der Krafteinleitungselemente 9 mit der Schelle 8 denkbar. Insbesondere können die Krafteinleitungselemente 9 auch zum Teil in die Schelle 8 eingebettet vorgesehen sein.

Fig. 8 zeigt eine Draufsicht auf die Strukturanordnung 10 nach Fig. 6 und 7.

In dieser Ansicht ist nochmals die umlaufende Ausbildung der Schelle 8 erkennbar. Ferner geht aus Fig. 6 ebenso wie in Fig. 1 die schraubenförmig gewickelte Struktur des Gewebes 3 der Verbundstruktur 2 hervor.

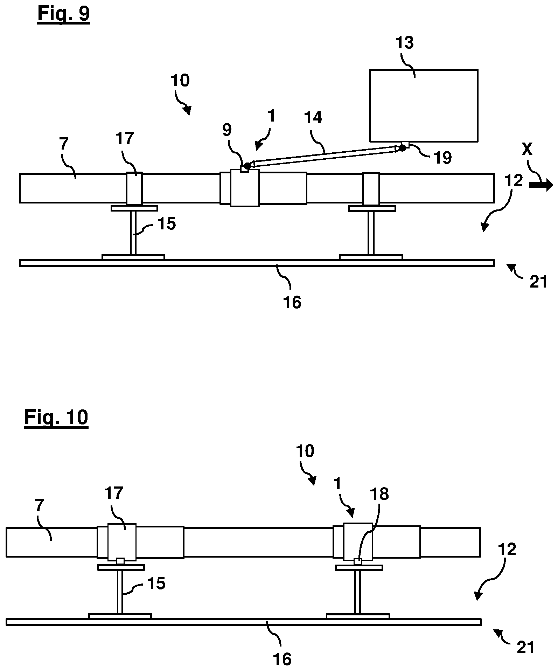

Fig. 9 zeigt eine Draufsicht auf eine Strukturanordnung 10 gemäß einer weiteren Ausführungsform.

Das Strukturprofil 7 ist hier als an eine Primärstruktur 12 eines Luft-oder Raumfahrzeugs angebundenes Strukturrohr ausgebildet. Das Strukturrohr ist zur Anbindung einer Komponente 13 an die Primärstruktur 12 zu deren Abstützung in Flugrichtung X ausgebildet.

Die Primärstruktur 12 ist hier lediglich schematisch dargestellt und weist rein beispielhaft mehrere Spante 15 sowie eine Haut 16 eines Rumpfes 21 eines Luft-oder Raumfahrzeugs 20 auf. Das Strukturrohr verläuft in Flugrichtung X und ist axial an dem Rumpf 21 angeordnet. Das Strukturrohr ist dabei jeweils an die Spante 15 angebunden, beispielsweise mittels Rohrschellen 17.

Das Strukturrohr bildet mit einem Verstärkungselement 1 eine Strukturanordnung 10 aus, wie sie im Wesentlichen in Bezug auf die Figuren 6 bis 8 beschrieben ist. An zumindest einem Krafteinleitungselement 9 des Verstärkungselements 1 ist dabei eine Samerstange 14 mit einem Ende angelenkt, die mit ihrem anderen Ende über ein Kraftübertragungselement 19 an der Komponente 13 angelenkt ist. Auf diese Weise ist die Komponente 13 über das Verstärkungselement 1 an das Strukturrohr angebunden und so eine axiale Abstützung in X-Richtung für die Komponente 13 bereitgestellt.

Bei einer solchen Komponente 13 kann es sich beispielsweise um ein Kabinenelement handeln, welches auf diese Weise in Flugrichtung X abgestützt ist. Beispielsweise kann als Komponente 13 eine Bordküche, eine Bordtoilette oder ein anderes Kabinenmonument vorgesehen sein.

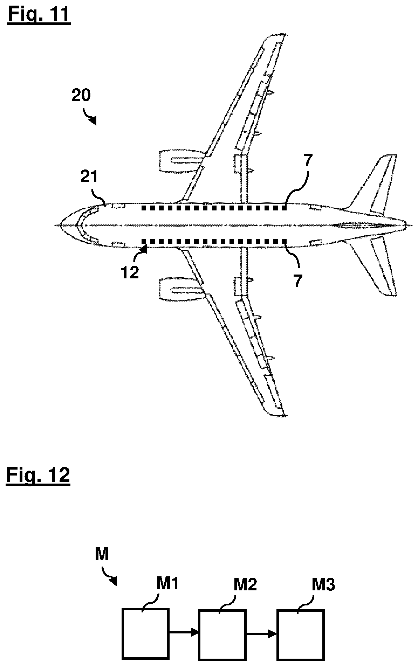

Besonders vorteilhaft lässt sich auf diese Weise eine besonders einfache Montage derartiger Komponenten 13 realisieren. Ein Verfahren zur Herstellung einer derartigen Strukturanordnung 10 kann dabei Fig. 12 als Flussdiagramm entnommen werden. Das Verfahren M umfasst unter M1 Anordnen eines ungeschrumpften Verstärkungselements 1 auf den Strukturprofil 7 unter Anlegen einer elektrischen Spannung U derart, dass die innere Mantelfläche 5 das Strukturprofil 7 lokal umgibt. Das Verfahren M umfasst unter M2 ferner Vornehmen eines Toleranzausgleichs durch Verschieben des Verstärkungselements 1 entlang des Strukturprofils 7 in eine finale Position. Das Verfahren M umfasst unter M3 ferner Abschalten der elektrischen Spannung U zum Befestigen der inneren Mantelfläche 5 an dem Strukturprofil 7 durch Schrumpfen der Verbundstruktur 2.

Zur Anbindung der Komponente 13 an das Strukturprofil 7 umfasst das Vornehmen des Toleranzausgleichs das Koppeln der Komponente 13 mit dem Verstärkungselement 1 und ein finales Positionieren der Komponente 13 in ihrer Einbauposition. Dazu kann das Verstärkungselement axial frei verschoben werden. Anschließend kann die Komponente 13 durch das Schrumpfen der Verbundstruktur 2 des Verstärkungselements 1 in der Einbauposition an das Strukturprofil 7 angebunden werden. Auf diese Weise sind vorteilhaft keinerlei zusätzliche toleranzausgleichende Maßnahmen, wie Loslager oder dergleichen, nötig.

Fig. 10 zeigt eine Draufsicht auf eine Strukturanordnung 10 gemäß einer noch weiteren Ausführungsform.

Bei dieser Ausführungsform ist ebenfalls ein Verstärkungselement 1 vorgesehen, wobei dieses hier zur Anbindung des Strukturrohrs an die Primärstruktur 12 vorgesehen ist. Anstatt der gelenkigen Krafteinleitungselemente 9 sind hier mit den Spanten 15 befestigte Sockel 18 vorgesehen, welche mit der Schelle 8 befestigt sind. In dem ungeschrumpften Zustand lässt sich das in die Verstärkungselemente 1 eingeschobene Strukturrohr darin axial frei verschieben.

Das Verfahren zur Herstellung der Strukturanordnung 10 verläuft hier im Wesentlichen gleich wie in Bezug auf Fig. 9 beschrieben, mit dem Unterschied, dass das Strukturprofil relativ zum Verstärkungselement zum Toleranzausgleich frei beweglich ist. Durch das Verstärkungselement 1 lassen sich hier somit Toleranzen ausgleichen, insbesondere Fertigungstoleranzen der Primärstruktur 12. Nach einer finalen Positionierung lässt sich das Strukturrohr dann anschließend durch Abschalten der elektrischen Spannung U befestigen. Beispielsweise lassen sich somit axiale Fertigungstoleranzen eines Flugzeugrumpfes ohne zusätzliche Maßnahmen leicht ausgleichen.

Selbstverständlich kann diese Art der Anbindung des Strukturrohrs mit der Anbindung einer Komponente 13 gemäß Fig. 9 kombiniert werden. Dazu kann ein zusätzliches Verstärkungselement 1 vorgesehen sein oder ggfs. auch ein zur Anbindung an die Primärstruktur 12 ohnehin vorhandenes Verstärkungselement 1 mit zusätzlichen Krafteinleitungselementen versehen sein.

Fig. 11 zeigt eine Draufsicht auf ein Luft- oder Raumfahrzeug 20.

Das Luft- oder Raumfahrzeug 20 weist einen Rumpf 21 auf, der die in Bezug auf Fig. 9 und 10 beschriebene Primärstruktur 12 aufweist. Lediglich schematisch mit gestrichelten Linien ist das Strukturprofil 7 zur Verdeutlichung des axialen Verlaufs eingezeichnet, welches an der Primärstruktur 12 angebunden ist. Die Anbindung an die Primärstruktur 12 kann insbesondere gemäß Fig. 10 ausgebildet sein. Das Strukturprofil 7 ist zur Abstützung von Kabinenelementen, wie Bordküchen, Bordtoiletten oder anderen Kabinenmonumenten, als Komponenten 13 in axialer Richtung X vorgesehen und als durch das Verstärkungselement 1 verstärktes Strukturrohr ausgebildet.

In der vorangegangenen detaillierten Beschreibung sind verschiedene Merkmale zur Verbesserung der Stringenz der Darstellung in einem oder mehreren Beispielen zusammengefasst worden. Es sollte dabei jedoch klar sein, dass die obige Beschreibung lediglich illustrativer, keinesfalls jedoch beschränkender Natur ist. Sie dient der Abdeckung aller Alternativen, Modifikationen und Äquivalente der verschiedenen Merkmale und Ausführungsbeispiele. Viele andere Beispiele werden dem Fachmann aufgrund seiner fachlichen Kenntnisse in Anbetracht der obigen Beschreibung sofort und unmittelbar klar sein.

Die Ausführungsbeispiele wurden ausgewählt und beschrieben, um die der Erfindung zugrundeliegenden Prinzipien und ihre Anwendungsmöglichkeiten in der Praxis bestmöglich darstellen zu können. Dadurch können Fachleute die Erfindung und ihre verschiedenen Ausführungsbeispiele in Bezug auf den beabsichtigten Einsatzzweck optimal modifizieren und nutzen. In den Ansprüchen sowie der Beschreibung werden die Begriffe "beinhaltend" und "aufweisend" als neutralsprachliche Begrifflichkeiten für die entsprechenden Begriffe "umfassend" verwendet. Weiterhin soll eine Verwendung der Begriffe "ein", "einer" und "eine" eine Mehrzahl derartig beschriebener Merkmale und Komponenten nicht grundsätzlich ausschließen.

### Bezugszeichenliste

- 1: Verstärkungselement
- 2: Verbundstruktur
- 3: Geflecht
- 4: Faserstrang
- 5: innere Mantelfläche
- 6: Matrixmaterial
- 7: Strukturprofil
- 7a: Längsabschnitt
- 8: Schelle
- 9: Krafteinleitungselement
- 10: Strukturanordnung
- 11: Aufnahme
- 12: Primärstruktur
- 13: Komponente
- 14: Samerstange
- 15: Spant
- 16: Haut
- 17: Rohrschelle
- 18: Sockel
- 19: Kraftübertragungselement
- 20: Luft- oder Raumfahrzeug
- 21: Rumpf
- U: elektrische Spannung
- X: Flugzeug X-Richtung
- M: Verfahren
- M1-M3: Verfahrensschritte

## Patentansprüche

1. Verstärkungselement (1) für ein Strukturprofil (7), insbesondere für ein rundes, ovales oder elliptisches Strukturrohr, mit:
einer Verbundstruktur (2), welche ein hohlzylindrisches schraubenförmig gewickeltes Geflecht (3) von Fasersträngen (4) aufweist, die eine zur Aufnahme des Strukturprofils (7) ausgebildete innere Mantelfläche (5) bilden, wobei die Faserstränge (4) jeweils in ein Matrixmaterial (6) eingebettet sind, welches ein elektroaktives Polymer aufweist, das durch Anlegen einer elektrischen Spannung (U) entlang einer Längserstreckung der Faserstränge (4) dehnbar ist, sodass die Verbundstruktur (2) durch Anlegen der elektrischen Spannung (U) ausdehnbar ist, um das Strukturprofil (7) in die Verbundstruktur (2) einzubringen, und durch Ausschalten der elektrischen Spannung (U) schrumpfbar ist, um das Strukturprofil (7) in der Verbundstruktur (2) an der Mantelfläche (5) zu fixieren.

2. Verstärkungselement (1) nach Anspruch 1, wobei die Faserstränge (4) jeweils zusammen mit dem Matrixmaterial (6) Materialstreifen bilden, die um die Mantelfläche (5) schraubenförmig herum gewickelt sind.

3. Strukturanordnung (10), insbesondere für ein Luft- oder Raumfahrzeug, mit:
einem Strukturprofil (7), insbesondere einem runden, ovalen oder elliptischen Strukturrohr; und
einem das Strukturprofil (7) lokal umgebenden Verstärkungselement (1) nach Anspruch 1 oder 2, wobei die Verbundstruktur (2) zur Aufbringung einer Zugsspannung geschrumpft und auf diese Weise kraftschlüssig mit dem Strukturprofil (7) verbunden ist.

4. Strukturanordnung (10) nach Anspruch 3, wobei das Strukturprofil (7) zwei Längsabschnitte (7a) aufweist, wobei das Verstärkungselement (1) zwei einander gegenüberliegende Enden der jeweiligen Längsabschnitte (7a) umgibt und die beiden Längsabschnitte (7a) derart miteinander verbindet.

5. Strukturanordnung (10) nach Anspruch 3 oder 4, wobei das Verstärkungselement (1) zur Versteifung des Strukturprofils (7), insbesondere zur lokalen Knickversteifung, und/oder zur Einleitung von axialen Lasten in das Strukturprofil (7) ausgebildet und angeordnet ist.

6. Strukturanordnung (10) nach einem der Ansprüche 3 bis 5, wobei das Verstärkungselement (1) eine mit der Verbundstruktur (2) gekoppelte Aufnahme (11) aufweist, die zur Übertragung von axialen Lasten (Fx) auf die Verbundstruktur (2) ausgebildet ist.

7. Strukturanordnung (10) nach einem der Ansprüche 3 bis 6, wobei die Verbundstruktur (2) derart ausgelegt ist, dass sich das Geflecht (3) von Fasersträngen (4) bei axialer Zugbelastung (Fx) axial längt und radial zusammenzieht, sodass sich der Kraftschluss mit dem Strukturprofil (7) selbsttätig verstärkt.

8. Luft- oder Raumfahrzeug (100) mit einer Strukturanordnung (10) nach einem der Ansprüche 3 bis 7.

9. Luft- oder Raumfahrzeug (100) nach Anspruch 8, wobei das Strukturprofil (7) als an eine Primärstruktur (12) des Luft- oder Raumfahrzeugs (20) angebundenes Strukturrohr zur Anbindung von zumindest einer Komponente (13) an die Primärstruktur (12) ausgebildet ist.

10. Luft- oder Raumfahrzeug (100) nach Anspruch 9, wobei das Strukturrohr axial an einer Rumpfstruktur (21) des Luft- oder Raumfahrzeugs (20) angeordnet ist.

11. Luft- oder Raumfahrzeug (100) nach Anspruch 9 oder 10, wobei die zumindest eine Komponente (13) über das Verstärkungselement (1) an das Strukturrohr angebunden ist und/oder das Strukturrohr über das Verstärkungselement (1) an der Primärstruktur (12) angebunden ist.

12. Luft- oder Raumfahrzeug (100) nach einem der Ansprüche 9 bis 11, wobei die Verbundstruktur (2) zur formstabilen Übertragung von herkömmlichen Fluglasten durch den mit der Schrumpfung der Verbundstruktur (2) aufgebrachten Kraftschluss auf das Strukturrohr ausgelegt ist.

13. Luft- oder Raumfahrzeug (100) nach einem der Ansprüche 8 bis 12, wobei die Verbundstruktur (2) zur formverändernden Übertragung von axialen Überlasten (Fx), insbesondere Crashlasten, auf das Strukturprofil (7) durch axiales Längen und radiales Zusammenziehen ausgelegt ist.

14. Verfahren (M) zur Herstellung einer Strukturanordnung (10), insbesondere einer Strukturanordnung (10) nach einem der Anspruche 3 bis 7, umfassend:
Anordnen (M1) eines ungeschrumpften Verstärkungselements (1) gemäß Anspruch 1 oder 2 auf einem Strukturprofil (7) unter Anlegen einer elektrischen Spannung (U) derart, dass die innere Mantelfläche (5) das Strukturprofil (7) lokal umgibt;
Vornehmen (M2) eines Toleranzausgleichs durch Verschieben des Verstärkungselements (1) entlang des Strukturprofils (7) in eine finale Position; und
Abschalten (M3) der elektrischen Spannung (U) zum Befestigen der inneren Mantelfläche (5) an dem Strukturprofil (7) durch Schrumpfen der Verbundstruktur (2).

15. Verfahren (M) nach Anspruch 14, wobei das Verstärkungselement (1) zur Anbindung einer Komponente (13) an das Strukturprofil (7) ausgebildet ist, wobei das Vornehmen des Toleranzausgleichs das Koppeln der Komponente (13) mit dem Verstärkungselement (1) und ein finales Positionieren der Komponente (13) in ihrer Einbauposition umfasst, sodass die Komponente (13) durch das Schrumpfen der Verbundstruktur (2) des Verstärkungselements (1) in der Einbauposition an das Strukturprofil (7) angebunden wird.

## Claims

1. Reinforcing element (1) for a structural profile (7), in particular for a round, oval or elliptical structural tube, with: a composite structure (2) which has a hollow cylindrical helically wound mesh (3) of fiber strands (4) which form an inner lateral surface (5) designed to accommodate the structural profile (7), wherein the fiber strands (4) are each embedded in a matrix material (6) which has an electroactive polymer which can be stretched along a longitudinal extension of the fiber strands (4) by applying an electrical voltage (U), so that the composite structure (2) can be expanded by applying the electrical voltage (U) in order to introduce the structural profile (7) into the composite structure (2), and can be shrunk by switching off the electrical voltage (U) in order to fix the structural profile (7) in the composite structure (2) to the lateral surface (5).

2. Reinforcing element (1) according to claim 1, wherein the fiber strands (4) together with the matrix material (6) form strips of material which are wound helically around the lateral surface (5).

3. Structural arrangement (10), in particular for an aircraft or spacecraft, with: a structural profile (7), in particular a round, oval or elliptical structural tube; and a reinforcing element (1) locally surrounding the structural profile (7) according to claim 1 or 2, wherein the composite structure (2) is shrunk to apply a tensile stress and is thus non-positively connected to the structural profile (7).

4. Structural arrangement (10) according to claim 3, wherein the structural profile (7) has two longitudinal sections (7a), wherein the reinforcing element (1) surrounds two opposite ends of the respective longitudinal sections (7a) and connects the two longitudinal sections (7a) to one another in this way.

5. Structural arrangement (10) according to claim 3 or 4, wherein the reinforcing element (1) is designed and arranged to stiffen the structural profile (7), in particular for local buckling stiffening, and/or to introduce axial loads into the structural profile (7).

6. Structural arrangement (10) according to one of claims 3 to 5, wherein the reinforcing element (1) has a receptacle (11) coupled to the composite structure (2) which is designed to transmit axial loads (Fx) to the composite structure (2).

7. Structural arrangement (10) according to one of claims 3 to 6, wherein the composite structure (2) is designed such that the mesh (3) of fiber strands (4) elongates axially and contracts radially under axial tensile load (Fx), so that the frictional connection with the structural profile (7) is automatically reinforced.

8. Aircraft or spacecraft (100) with a structural arrangement (10) according to one of claims 3 to 7.

9. Aircraft or spacecraft (100) according to claim 8, wherein the structural profile (7) is designed as a structural tube connected to a primary structure (12) of the aircraft or spacecraft (20) for connecting at least one component (13) to the primary structure (12).

10. Aircraft or spacecraft (100) according to claim 9, wherein the structural tube is arranged axially on a fuselage structure (21) of the aircraft or spacecraft (20).

11. Aircraft or spacecraft (100) according to claim 9 or 10, wherein the at least one component (13) is connected to the structural tube via the reinforcing element (1) and/or the structural tube is connected to the primary structure (12) via the reinforcing element (1).

12. Aircraft or spacecraft (100) according to one of claims 9 to 11, wherein the composite structure (2) is designed for the dimensionally stable transfer of conventional flight loads to the structural tube by the frictional connection applied with the shrinkage of the composite structure (2).

13. Aircraft or spacecraft (100) according to one of claims 8 to 12, wherein the composite structure (2) is designed for the shape-changing transfer of axial overloads (Fx), in particular crash loads, to the structural profile (7) by axial lengthening and radial contraction.

14. Method (M) for producing a structural arrangement (10), in particular a structural arrangement (10) according to one of claims 3 to 7, comprising:
Arranging (M1) an unshrunk reinforcing element (1) according to claim 1 or 2 on a structural profile (7) while applying an electrical voltage (U) such that the inner lateral surface (5) locally surrounds the structural profile (7);
Carrying out (M2) a tolerance compensation by moving the reinforcing element (1) along the structural profile (7) into a final position; and
switching off (M3) the electrical voltage (U) for fastening the inner lateral surface (5) to the structural profile (7) by shrinking the composite structure (2).

15. Method (M) according to claim 14, wherein the reinforcing element (1) is designed to connect a component (13) to the structural profile (7), wherein carrying out the tolerance compensation comprises coupling the component (13) to the reinforcing element (1) and finally positioning the component (13) in its installation position, so that the component (13) is connected to the structural profile (7) by shrinking the composite structure (2) of the reinforcing element (1) in the installation position.

## Revendications

1. Elément de renforcement (1) pour un profil structurel (7), notamment pour un tube de structure rond, ovale ou elliptique, comprenant: une structure composite (2) qui présente une tresse cylindrique creuse enroulée en hélice (3) de brins de fibres (4) qui forment une surface d'enveloppe intérieure (5) conçue pour recevoir le profil structurel (7), dans lequel les brins de fibres (4) sont chacun noyés dans un matériau de matrice (6) qui comprend un polymère électroactif qui, en appliquant une tension électrique (U) le long d'une extension longitudinale des brins de fibres (4) est extensible, de sorte que la structure composite (2) est extensible en appliquant la tension électrique (U) afin d'introduire le profil structurel (7) dans la structure composite (2) et est rétractable par coupure de la tension électrique (U) afin de fixer le profil structurel (7) dans la structure composite (2) à la surface d'enveloppe intérieure (5).

2. Elément de renforcement (1) selon la revendication 1, dans lequel les brins de fibres (4) forment chacun avec le matériau de matrice (6) des bandes de matériau qui sont enroulées hélicoïdalement autour de la surface d'enveloppe intérieure (5).

3. Arrangement structurel (10), notamment pour un aéronef ou un véhicule spatial, comprenant: un profil structurel (7), notamment un tube structurel rond, ovale ou elliptique; et un élément de renforcement (1) selon la revendication 1 ou 2 entourant localement le profil structurel (7), dans lequel la structure composite (2) est rétrécie pour appliquer une contrainte de traction et est ainsi reliée de manière non positive au profil structurel (7).

4. Arrangement structurel (10) selon la revendication 3, dans lequel le profil structurel (7) présente deux sections longitudinales (7a), dans lequel l'élément de renforcement (1) entoure deux extrémités opposées des sections longitudinales respectives (7a) et relie les deux sections longitudinales (7a) les unes aux autres de telle manière.

5. Arrangement structurel (10) selon la revendication 3 ou 4, dans lequel l'élément de renforcement (1) est conçu et disposé pour rigidifier le profil structurel (7), en particulier pour un raidissement local du flambage, et/ou pour introduire des charges axiales dans le profil structurel (7).

6. Arrangement structurel (10) selon l'une des revendications 3 à 5, dans lequel l'élément de renforcement (1) présente un réceptacle (11) couplé à la structure composite (2) qui est conçu pour transmettre des charges axiales (Fx) à la structure composite (2).

7. Arrangement structurel (10) selon l'une des revendications 3 à 6, dans lequel la structure composite (2) est conçue de telle sorte que la tresse (3) de brins de fibres (4) s'allonge axialement et se contracte radialement sous une charge de traction axiale (Fx), de sorte que la liaison par friction avec le profil structurel (7) est automatiquement renforcée.

8. Aéronef ou véhicule spatial (100) comprenant un arrangement structurel (10) selon l'une des revendications 3 à 7.

9. Aéronef ou véhicule spatial (100) selon la revendication 8, dans lequel le profil structurel (7) est conçu comme un tube structurel relié à une structure primaire (12) de l'aéronef ou du véhicule spatial (20) pour relier au moins un composant (13) à la structure primaire (12).

10. Aéronef ou véhicule spatial (100) selon la revendication 9, dans lequel le tube structurel est disposé axialement sur une structure de fuselage (21) de l'aéronef ou véhicule spatial (20).

11. Aéronef ou véhicule spatial (100) selon la revendication 9 ou 10, dans lequel le ou les composants (13) sont reliés au tube structurel par l'intermédiaire de l'élément de renforcement (1) et/ou le tube structurel est relié à la structure primaire (12) via l'élément de renforcement (1).

12. Aéronef ou véhicule spatial (100) selon l'une des revendications 9 à 11, dans lequel la structure composite (2) est conçue pour la transmission dimensionnellement stable de charges de vol conventionnelles par la liaison par friction au tube structurel appliquée avec le retrait de la structure composite (2).

13. Aéronef ou véhicule spatial (100) selon l'une des revendications 8 à 12, dans lequel la structure composite (2) est conçue pour la transmission par changement de forme de surcharges axiales (Fx), en particulier de charges de collision, au profil structurel (7) par allongement axial et contraction radiale.

14. Procédé (M) de fabrication d'un arrangement structurel (10), notamment d'un arrangement structurel (10) selon l'une des revendications 3 à 7, comprenant:
Disposer (M1) un élément de renforcement non rétréci (1) selon la revendication 1 ou 2 sur un profil structural (7) tout en appliquant une tension électrique (U) de telle sorte que la surface d'enveloppe intérieure (5) entoure localement le profil structural (7);
Réalisation (M2) d'une compensation de tolérance en déplaçant l'élément de renforcement (1) le long du profil structurel (7) jusqu'à une position finale; et
couper (M3) la tension électrique (U) pour fixer la surface d'enveloppe intérieure (5) au profil structurel (7) en rétrécissant la structure composite (2).

15. Procédé (M) selon la revendication 14, dans lequel l'élément de renforcement (1) est conçu pour relier un composant (13) au profil structurel (7), dans lequel la réalisation de la compensation de tolérance implique le couplage du composant (13) à l'élément de renforcement (1) et un positionnement final des composants (13) dans sa position d'installation, de sorte que le composant (13) est relié au profil structurel (7) par le retrait de la structure composite (2) de l'élément de renforcement (1) dans la position d'installation.
